(19) **Europäisches Patentamt / European Patent Office / Office européen des brevets**

(11) **EP 2 180 533 B1**

(12) **EUROPEAN PATENT SPECIFICATION**

(45) Date of publication and mention
of the grant of the patent:
**10.12.2014 Bulletin 2014/50**

(51) Int Cl.:
*H01L 33/50* (2010.01)        *H01L 33/58* (2010.01)

(21) Application number: **09013204.4**

(22) Date of filing: **20.10.2009**

(54) **Light emitting diode**

Leuchtdiode

Diode électroluminescente

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **21.10.2008 JP 2008270742**

(43) Date of publication of application:
**28.04.2010 Bulletin 2010/17**

(73) Proprietor: **Panasonic Electric Works Co., Ltd.
Kadoma-shi
Osaka 571-8686 (JP)**

(72) Inventor: **Takashi, Saito
Hirakata, Osaka (JP)**

(74) Representative: **Rüger, Barthelt & Abel
Postfach 10 04 61
73704 Esslingen a.N. (DE)**

(56) References cited:
**JP-A- 2004 349 647        JP-A- 2007 048 883
US-A1- 2008 210 961**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

**Description**

[Field of the Invention]

The present invention relates to a light emitting device, and more specifically to a light source for an advertising sign to be used indoors and outdoors.

[Background Art]

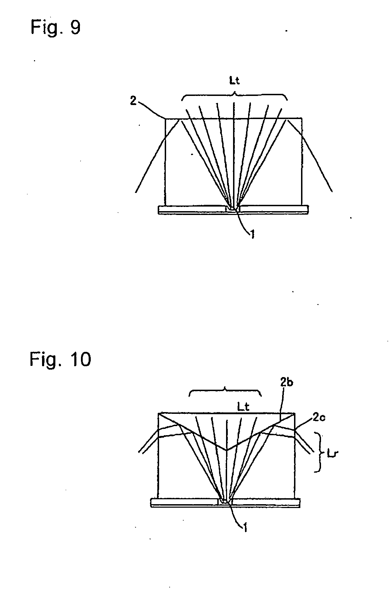

An LED element has progressed so as to output higher power, and has been gaining attention as an energy-saving and a clean light source free from environmental load substances, instead of light sources such as a bulb and a fluorescent lamp.
Since the LED element is manufactured based on the semiconductor manufacturing technique, which has the features that provides the excellent mass productivity and cost-saving property. Further, since the LED element is a point light source, a plurality of LED elements are required to be appropriately placed to obtain a desired illumination intensity as a surface light emitting device while suppressing the irregular illumination intensity.
Still further, although luminance of the surface light emitting device using the LED element depends on a light-emitting characteristic of the LED element as the light-emitting source, it is known that the irregular color and the irregular illumination intensity exist as the light-emitting characteristic in a single LED element. It is thus required for the application to which a higher quality is demanded to gather the LED elements which have a uniform light-emitting characteristic.
Then, a configuration has been offered in which the optical element is attached as shown in Figs. 9 and 10 in order to propose the structure capable of making the illumination intensity uniform even if each LED element exhibits the variation in the light-emitting characteristic thereof (Patent Document 1).
Fig. 9 depicts a surface of an optical element 2 opposite to the LED element being parallel to the LED element 1, and Fig. 10 depicts a surface being formed at a certain angle with respect to the LED element 1 to form a total reflecting surface. In the configuration shown in Fig. 10, light emitted from a light-emitting part of the LED element 1 enters into a light direction converting optical element (a lens portion) 2 from an incident surface of the light direction converting optical element 2 through an incident layer, and then is focused within a critical angle by refraction. The light then reaches a reflecting surface 2b. The reflecting surface 2b is formed at an angle entirely reflecting all the ray of light reached from the LED element 1.
Thus, the light is entirely reflected at the reflecting surface 2b, and reaches a side wall surface 2c to be refracted, thereby being emitted to the outside of the light direction converting optical element 2. Lt designates transmitted light, and Lr designates reflected light.
Therefore, according to this structure, the light is divided into the one emitted from the side wall surface 2c and the one emitted from a center of a surface opposite to the incident surface. The light from the side wall surface can provide an optical output having a wide view angle.
In addition, in order to obtain light of a desired color, a structure has been also offered in which the light direction converting optical element 2 as the lens part includes an optical converting member (coloring material) for converting spectral distribution of light.
Such structure, however, varies the distances between entering and emitting of the light from a light-emitting package in which the LED element 1 is sealed to the light direction converting optical element 2, as shown in Fig. 10. Therefore, in the case where the light direction converting optical element 2 as the lens part contains the optical converting member for converting spectral distribution of light, if a content amount of the optical converting member is uniform, the light having a long optical path is converted at a high rate (the color becomes darker). This gives a different impression of color compared to the light having a short optical path, resulting in more of irregular color as a whole. (Patent document 2)
Patent Document 1: Japanese Unexamined Patent Publication No. 2007-48883
Patent Document 2 : US 2008/0210961 A1

[Disclosure of the Invention]

[Problems to be Solved by the Invention]

As described above, since a light emitting device in the Patent Document 1 includes a uniform content amount of an optical converting member regardless of an optical path length, the phenomenon may occur in which the color of transmitted light emitted from the center of a lens differs from that of reflected light reflected at the lens to be emitted from a side surface.
In view of the foregoing, the purpose of the present invention is to provide a light emitting device which can achieve constant coloring even when the path length varies, resulting in uniform light without irregular color.

[Means Adapted to Solve the Problems]

In order to achieve the above-mentioned object, a light emitting device of the present invention according to Claim 1 is provided.

Furthermore, the light emitting device according to the present invention includes the transmitting surface of the lens that comes closest to the light source on a central axis passing through a center of the light source, and becomes thicker toward a peripheral portion being away from the surface containing the light source.

[Effect of the Invention]

As described above, with the above-mentioned structure, even in the case where light which is emitted from the light source such as a light-emitting diode and transmitted through the lens is greatly different from the light which is reflected and emitted to the side surfaces in the optical path length, variation of an extent of coloring by the optical converting member in the lens can be decreased and the color of the transmitted light can be made substantially the same as that of direct light.

Furthermore, with the above-mentioned structure, irregular luminescence and irregular color can be decreased and in the case of the device being used as an advertising sign, an advertising sign plane can be evenly illuminated.

In manufacturing, by filling the first region with the resin material and hardening the first region after filling the second region with the resin material and hardening the second region, the percentage of a content ratio of the optical converting member in the vicinity of the center of the lens to a content ratio in the vicinity of the periphery can be set with a higher accuracy and thus, the number of prototypes in a manufacturing process can be reduced.

[Best Mode for Carrying Out the Invention]

Embodiments of the present invention will be described below.

(First embodiment)

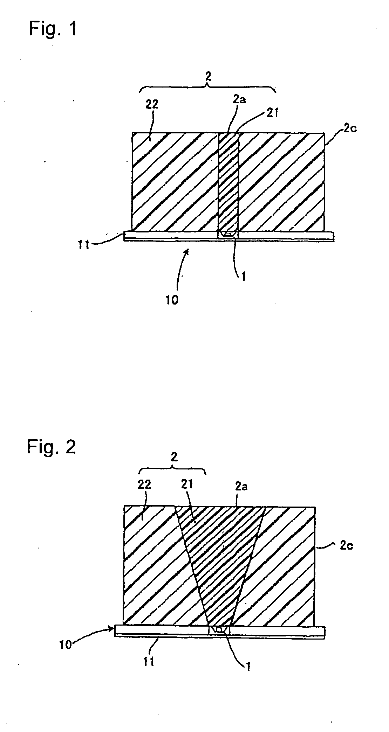

Fig. 1 is an explanatory view showing a light-emitting panel according to a first embodiment of the present invention. The light-emitting panel is structured as a light emitting device having an LED element 1 as a light source, and a lens 2 as an optical element that includes an optical converting member containing a coloring agent for converting spectral distribution of light from the LED element, wherein the lens 2 has a larger content amount of the optical converting member in a portion of a relatively short optical path length from the LED element 1 than a content amount of the optical converting member in a portion of a relatively long optical path.

More specifically, the lens 2 has a reflecting surface for reflecting light from the LED element 1 to emit the light in a side direction of the lens, and a transmitting surface transmitting light from the light source and emitting the light in a direction across the lens and opposite to the light source, and is structured to include a larger content amount of the optical converting member at least in a region where the light source and the transmitting surface are facing in an opposed manner than a content amount of the optical converting member in the peripheral portion of the lens.

Here, the lens includes a region where the LED element 1 and the transmitting surface 2a are facing in an opposed manner, which is divided into a first region 21 including a large content amount of the optical converting member, and a second region 22 located on the periphery of the first region and including a less content amount of the optical converting member than that of the first region. A boundary surface between the first region 21 and the second region 22 is perpendicular to a surface of a printed wiring board 11 on which the LED element 1 is placed. The lens is formed of a light transmissive resin, such as an epoxy resin, and a phosphor particle is included as an optical converting member in the epoxy resin. As the phosphor particle, inorganic particles are used, such as the one in which yttrium oxide is used as a light-emitting base body and europium is added as an activator, or the one in which manganese is added as an activator to silicate.

In addition, the LED element 1 is mounted on the printed wiring board 11, in which a peripheral circuit element is formed, to constitute a light-emitting module 10.

Moreover, the LED element 1 includes a lead frame (not shown) with an LED chip mounted thereon.

This structure uses the LED element as the light source, or a light source having a light-emitting area and an emission intensity ability corresponding to the LED element. The lens 2 is placed on the entire surface thereof. As shown in Fig. 1, the light from the LED element 1 is emitted directly in the vicinity of the center of the lens 2, whereas the light form the LED element 1 is reflected to be emitted from a side surface 2c in the vicinity of the periphery of the lens. Therefore, an optical path length of the light passing through the vicinity of the center of the lens significantly differs from that of the light passing through the vicinity of the periphery of the lens; the optical path is longer for the light passing through the vicinity of the periphery of the lens.

In contrast, in the case where light passes the optical converting member to change the spectral distribution thereof, the coloring is enhanced when a content ratio of the optical converting member is high, or when the optical path length passing through the lens is long. Therefore, in this case, the content amount of the optical converting member in the first region 21 in the vicinity of the center of the lens, which is a region of a short optical path length, is thus larger than the content amount of the optical converting member in the second region 22 in the vicinity of the periphery of the lens, which is a region of a long optical path length.

According to this structure, even in the case where the light from the LED element 1 passing through the lens to emit from the transmitting surface 2a is greatly different from the light which is reflected and emitted to the side surface 2c in the optical path length, variation of an extent of coloring by the optical converting member in the lens can be decreased, and the color of the light passing through the first region 21 to exit from the transmitting surface 2a can be made substantially the same as the color of the light reflected to pass through the second region 22 to exit from the side surface 2c.

Accordingly, with the above-mentioned structure, irregular luminescence and irregular color can be decreased, and in the case of the light-emitting panel being used as an advertising sign, an advertising sign plane can be evenly illuminated.

In manufacturing, by filling the first region 21 with the resin material including an epoxy resin to which much more fluorescent substance is added and hardening the first region after filling the second region 22 with the resin material including an epoxy resin to which more fluorescent substance is added and hardening the second region, the percentage of a content ratio of the optical converting member in the vicinity of the center of the lens to a content ratio in the vicinity of the periphery of the lens can be set with higher accuracy and thus, the number of prototypes in a manufacturing process can be reduced.

(Second embodiment)

Fig. 2 is an explanatory view showing a light-emitting panel according to a second embodiment of the present invention. As shown in Fig. 2, although this light-emitting panel has a same basic configuration as that of the light-emitting panel in the first embodiment, while a difference is found in the boundary surface between the first region 21 including a large content amount of the optical converting member and the second region 22 on the periphery thereof. The boundary surface forms not a perpendicular surface but an inclined surface with respect to the light-emitting module 10. More specifically, the boundary surface between the first region 21 and the second region 22 takes the shape of an inverted cone formed so that the first region 21 expands from the LED element 1 to the periphery.

This is because the light passing through the lens has a reflection angle (critical angle) that varies depending on a ratio of transmittance between air and the material constituting the lens. Such light transmits at an angle larger than the critical angle, and reflects at an angle smaller than the critical angle. The content amount of the optical converting member in the lens is varied setting the critical angle $\theta$ as the boundary.

The light-emitting panel of the second embodiment is also structured, similar to that of the embodiment 1, to have the LED element 1 as a light source, and the lens 2 that includes the optical converting member containing a coloring agent for converting spectral distribution of light from the LED element, wherein the lens 2 has a larger content amount of the optical converting member in a portion of a relatively short optical path length from the LED element 1 than the content amount of the optical converting member in a region of a relatively long optical path.

A method for manufacturing the lens of the second embodiment is as follows. Molding frames, one is adapted to a shape of the portion in the vicinity of the center of the lens and the other is adapted to the shape of an outer frame of the lens, are prepared. First, a lens material containing the optical converting member is poured into the molding frame adapted to the shape of the portion in the vicinity of the center of the lens and solidified to form the first region. Then, a solidified material is fixed only to the center portion of the lens in the molding frame adapted to the outer frame of the lens, and the portion around the center portion is filled with the optical converting member to be solidified, thereby forming the second region. The manufacturing can be readily carried out.
The amount of the phosphor can be suitably changed, and preferably is calculated by running a simulation and the like.

(Third embodiment)

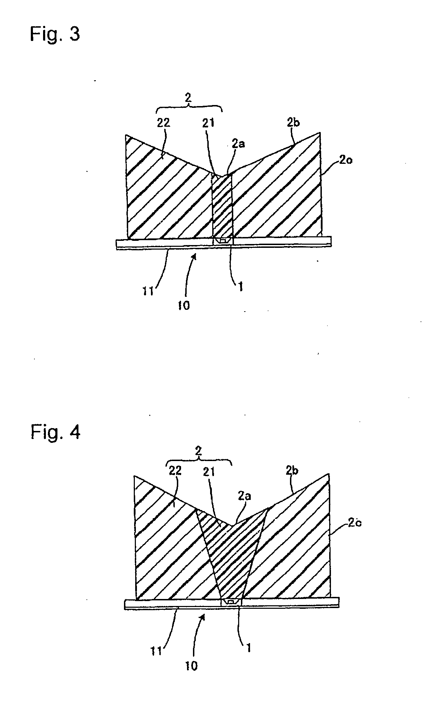

Fig. 3 is an explanatory view showing a light-emitting panel according to a third embodiment of the present invention. As shown in Fig. 3, this light-emitting panel has a same basic configuration as that of the light-emitting panel in the first embodiment, while in the light emitting device, the lens 2 has a reflecting surface 2r for reflecting light from the LED element 1 to emit the light in a side direction of the lens 2, and the transmitting surface 2a for transmitting the light from the LED element 1 to emit the light in the direction across the lens 2 and opposite to the LED element 1, wherein at least a part of the light transmitting through the transmitting surface 2a includes a larger content amount of the optical converting member than that in the other part.

As described above, in the present embodiment, a same basic configuration as that in the first embodiment, whereas the lens is structured so that a center portion between a surface on which the LED element 1 and an opposing surface across the lens 2 is placed is concaved, and thus the height of the concave becomes shallower toward the periphery of the lens.

This configuration includes a structure in which a center portion between a surface on which the LED element 1 and an opposing surface across the lens 2 is placed is concaved, so that the light emitted from the LED element can be reflected to pass through the second region 22, and then efficiently exited from the side surface 2c. Thus, even in the case where the light from the LED element 1 passing and emitting through the lens is greatly different from the light which is reflected and emitted to the side surface 2c in the optical path length, variation of an extent of coloring by the optical converting member in the lens can be decreased, and the color of the light passing through the first region 21 to exit from the transmitting surface 2a can be made substantially the same as the color of the light reflected to pass through the second region 22 to exit from the side surface 2c.

Accordingly, with the above-mentioned configuration, irregular luminescence and irregular color can be decreased and in the case of the light-emitting panel being used as an advertising sign, an advertising sign plane can be evenly illuminated.

(Fourth embodiment)

Fig. 4 is an explanatory view showing a light-emitting panel according to a fourth embodiment of the present invention. As shown in Fig. 4, a basic structure of is similar to that of the light-emitting device in the second embodiment in which a boundary surface between the first region 21 and the second region 22 takes a shape of an inverted cone, whereas an outer profile of the lens is structured so that a center portion between a surface on which the LED element 1 and an opposing surface across the lens 2 is placed is concaved, similar to the third embodiment. Here, a content ratio M2/M1 of the optical converting members of the second region 22 to the first region 21 has a relationship as follows:

$$M2/M1 = c / [\{(a \cdot b) \cdot \sqrt{(1 + a^2)}\} \cdot d_1]$$

$$a = -\tan(\theta + \theta m)$$

$$b = -\tan(90° - 2\theta)$$

$$c = d_2 + l \times \tan(90° - 2\theta)$$

$$\theta = \tan^{-1}\{l / (d_2 - d_1)\}$$

$$\theta m = \sin^{-1}(l / nw)$$

$d_1$: Height of the central portion of the lens
$d_2$: Height of the peripheral portion of the lens
$l$: Radius
$\theta$ : Angle of the peripheral portion of the lens
nw: Transmittance of the lens.

This configuration enables much more light to be taken out from the side surface 2c, and also variation of an extent of coloring by the optical converting member in the lens can be effectively decreased. Therefore, the color of the light passing through the first region 21 to exit from the transmitting surface 2a can be made substantially the same as the color of the light reflected to pass through the second region 22 to exit from the side surface 2c.

Next, M2/M1, that is a ratio between a content amount of the optical converting member in the vicinity of the center of the lens and a content amount of the optical converting member in the vicinity of the periphery of the lens, will be described.

The extent of coloring of the light exited from the LED element when the light transmits the lens 2 is influenced by the content ratio τ of the optical converting member in the lens and a thickness t of the lens. Lambert-Beer law teaches that, if a product of the content ratio τ of the optical converting member and the thickness t of the lens is equal, the extent of coloring is equal. Accordingly, the optical path length being apparent can determine the content ratio of the optical converting member in the region. Here, the region is divided into two regions, the regions in the vicinity of the center and in the vicinity of the periphery, and then the percentage of their own content ratios of the optical converting member is calculated, respectively.

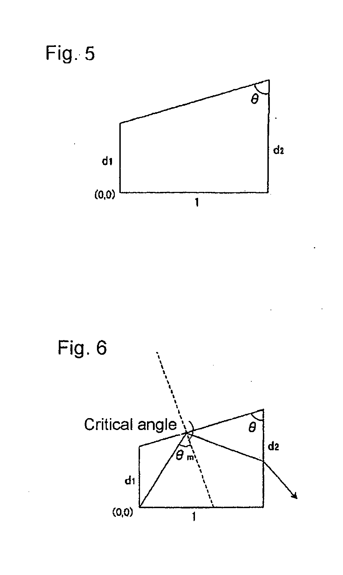

A calculation model is shown in Fig. 5 (since the lens is a rotating body to a central axis, the half of the shape of the cross sectional view of the lens is employed). The height of the center of the lens is designated as d1, the height of the periphery portion is designated as d2, the radius is designated as 1, and the angle of the peripheral portion of the lens is designated as θ. In addition, the transmittance of the lens is designated as nw. Moreover, a calculational origin point (0, 0) is designated as an intersection point of the central axis of the lens and a bottom surface.

Here, θ is determined as follows.

$$\theta = \tan^{-1}\left\{ l \,/\, (d_2 - d_1) \right\}$$

Here, as described in the second embodiment, the light exited from the light-emitting diode passes inside of the lens and is transmitted at an angle smaller than a certain critical angle, or emitted from the side surface 2c as the reflected light at an angle larger than the certain critical angle.

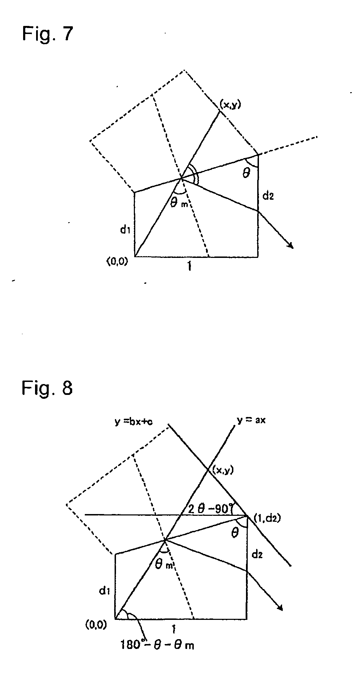

When considering an optical path length of the light to be reflected, the optical path length becomes longest when the reflection is made at the critical angle. Then, the optical path length thereof is a linear distance from the origin point to a coordinate (x, y) shown in Fig. 7. This optical path length is calculated as follows.

First, the coordinate (x, y) is determined.

As seen in Fig. 8, the coordinate (x, y) is the intersection point of the straight line y = ax passing through the origin point and the straight line y = bx + c passing through the coordinate (I, d2). The calculation of the intersection point determines x and y as follows.

$$x = c \,/\, (a{-}b)$$

$$y = ac \,/\, (a{-}b)$$

Therefore, a distance X between the origin point (0, 0) and the coordinate (c / (a-b), ac / (a-b)) is as follows.

$$X = c \,/\, (a{-}b)\ \sqrt{(1 + a^2)}$$

Here, in order to express a, b and c in an equation only by the values shown in the model in Fig. 5, the calculations are as follows.

$$a = -\tan\left(\theta + \theta m\right)$$

$$b = -\tan\left(90° - 2\theta\right)$$

$$c = d_2 + l \times \tan(90° - 2\theta)$$

$$\theta < 45°$$

Here, $\theta$ and $\theta m$ are expressed by the following equations.

$$\theta = \tan^{-1}\{l / (d_2 - d_1)\}$$

$$\theta m = \sin^{-1}(l / nw)$$

A maximum optical path length is thus determined. In contrast, a minimum optical path length is light passing through the center of the lens to be transmitted; the optical path length is $d_1$.
Therefore, the extent of coloring becomes approximately equal when the content ratio of the optical converting member in the vicinity of the center of the lens is on the order of

$$c / [\{(a-b) \cdot \sqrt{(1 + a^2)}\} \cdot d_1]$$

times compared to that in the vicinity of the periphery of the lens.
More specifically, the following

$$M2 / M1 = c / [\{(a-b) \cdot \sqrt{(1 + a^2)}\} \cdot d_1]$$

holds.
In addition, the result described above is applicable to not only the fourth embodiment, but also any of the first to fourth embodiments. In the aforementioned first to fourth embodiments, the content amount of the coloring material is changed in a stepwise manner from the first region to the second region, while the content amount of the coloring material may be continuously changed to become smaller as approaching from the first region to the second region. Further, the content amount of the coloring material may be continuously changed to become smaller with a distance from the light source becomes longer. While the computation becomes complicated, such formation can be realized by computing and designing by means of simulation.
Further, while the aforementioned first to fourth embodiments use a lens as an optical element, the present invention is applicable to a composite optical element other than the lens so that, for example, a part of the surface opposite to the printed wiring board is made as a metalized layer to constitute a reflecting surface.
Still further, while the aforementioned embodiments explain the example using the LED element as the light source, the present invention is applicable to the other light sources such as an organic EL element and an inorganic EL element.

[Brief Description of the Drawings]

[Fig. 1] Fig. 1 is an explanatory view showing a light emitting device according to a first embodiment of the present invention.
[Fig. 2] Fig. 2 is an explanatory view showing a light emitting device according to a second embodiment of the present invention.
[Fig. 3] Fig. 3 is an explanatory view showing a light emitting device according to a third embodiment of the present invention.

[Fig. 4] Fig. 4 is an explanatory view showing a light emitting device according to a fourth embodiment of the present invention.

[Fig. 5] Fig. 5 is a diagram showing a calculation model for determining an optical path length.

[Fig. 6] Fig. 6 is a diagram showing a critical angle.

[Fig. 7] Fig. 7 is a diagram showing a maximum optical path length.

[Fig. 8] Fig. 8 is a diagram showing a calculation process.

[Fig. 9] Fig. 9 is an explanatory view showing a conventional light emitting device.

[Fig. 10] Fig. 10 is an explanatory view showing a conventional light emitting device.

[Description of Reference Numerals]

1       LED element
2       Lens
2a      Transmitting surface
2b      Reflecting surface
2c      Side surface
21      First region
22      Second Region

**Claims**

1. A light emitting device comprising:

   a light source (1); and
   a lens containing an optical converting member for converting spectral distribution of light from the light source, **characterized in that** the lens has a larger content amount of the optical converting member in a portion of a relatively short optical path length from the light source than a content amount in a region of relatively long optical path,
   wherein the lens (2) includes a reflecting surface (2b) for reflecting light from the light source to emit the light in the side direction of the lens, and a transmitting surface (2a) for transmitting the light from the light source (1) to emit the light in the direction across the lens (2) and opposite to the light source (1),
   wherein the lens (2) includes a region where the light source (1) and the transmitting surface (2a) are facing in an opposed manner, wherein this region is divided into a first region (21) and a second region (22) located on the periphery of the first region (21) and containing an amount of the optical converting member less than that of the first region (21),
   wherein the content ratio M2/M1 of the optical converting member of the second region (22) with respect to the first region (21) has a relationship as follows:

$$M2/M1 = c / [\{(a-b) \cdot \sqrt{(1+a^2)}\} \cdot d1]$$

   where,

   $a = -\tan(\theta + \theta m)$
   $b = -\tan(90° - 2\theta)$
   $c = d2 + 1 \times \tan(90° - 2\theta)$
   $\theta = \tan^{-1}\{1/(d2-d1)\}$
   $\theta m = \sin^{-1}(1/nw)$
   $d_1$: Height of the central portion of the lens
   $d_2$: Height of the peripheral portion of the lens
   1: Radius
   $\theta$ : Angle of the peripheral portion of the lens
   nw: Transmittance of the lens.

2. The light emitting device according to claim 1, wherein:

the transmitting surface (2a) of the lens comes closest to the light source (1) on a central axis passing through a center of the light source, and becomes thicker toward a peripheral portion being away from a surface containing the light source.

**Patentansprüche**

1. Lichtemittierende Vorrichtung aufweisend:

eine Lichtquelle (1); und
eine Linse, die ein optisches Konvertierungsmittel zur Konvertierung der spektralen Verteilung des Lichts der Lichtquelle aufweist,
**dadurch gekennzeichnet, dass** die Linse in einem Bereich mit einer relativ kurzen optischen Weglänge von der Lichtquelle einen größeren Anteil des optischen Konvertierungsmittels aufweiset, als der Anteil in einem Bereich mit relativem langem optischen Weg,
wobei die Linse (2) eine reflektierende Fläche (2b) zum Reflektieren von Licht der Lichtquelle zum Emittieren des Lichts in eine seitliche Richtung der Linse sowie eine Austrittsfläche (2a) für den Austritt des Lichts der Lichtquelle (1) zum Emittieren des Lichts in eine Richtung quer zur Linse (2) und gegenüberliegend der Lichtquelle (1) aufweist,
wobei die Linse(2) einen Bereich aufweist, in dem die Lichtquelle (1) und die Austrittsfläche (2a) sich gegenüberliegen, wobei dieser Bereichs in eine ersten Bereich (21) und einen zweiten Bereich (22) unterteilt ist, der im Außenbereich des ersten Bereichs (21) angeordnet ist und der eine Menge des optischen Konvertierungsmittels aufweist, die kleiner ist als die des ersten Bereichs (21),
wobei das Anteilsverhältnis (M2/M1) des optischen Konvertierungsmittels des zweiten Bereichs (22) in Bezug auf den ersten Bereich (21) die folgende Beziehung aufweiset:

$$M2/M1 = c/[\{(a-b)\cdot\sqrt{(1 + a^2)}\}\cdot d_1]$$

wobei

$a = -\tan(\theta+\theta m)$
$b = -\tan(90°-2\theta$
$c = d_2 + 1 \times \tan(90°-2\theta)$
$\theta = \tan^{-1}\{1/(d_2-d_1)\}$
$\theta m = \sin^{-1}(1/nw)$
$d_1$: Höhe des zentralen Bereichs der Linse
$d_2$: Höhe des Außenbereichs der Linse
1: Radius
$\theta$: Winkel des Außenbereichs der Linse
nw: Transmission der Linse.

2. Lichtemittierende Vorrichtung nach Anspruch 1, wobei:

die Austrittsfläche (2a) der Linse der Lichtquelle (1) entlang einer zentralen Achse an nächsten ist, die durch ein Zentrum der Lichtquelle verläuft und in Richtung eines Außenbereichs von der die Lichtquelle enthaltenden Fläche weg dicker wird.

**Revendications**

1. Dispositif électroluminescent, comprenant :

une source (1) de lumière et

une lentille, contenant un élément de conversion optique, pour convertir la distribution spectrale de lumière depuis la source lumineuse,

**caractérisé en ce que** la lentille a une quantité de contenu de l'élément de conversion optique dans une partie d'une longueur de chemin optique relativement courte depuis la source lumineuse plus grande qu'une quantité de contenu dans une région d'un chemin optique relativement long,

dans lequel la lentille (2) comporte une surface réfléchissante (2b), destinée à réfléchir la lumière depuis la source lumineuse, pour émettre la lumière dans la direction latérale de la lentille et une surface (2a) de transmission, destinée à transmettre la lumière depuis la source lumineuse (1), pour émettre la lumière dans la direction à travers la gentille (2) et opposée à la source lumineuse (1),

dans lequel la lentille (2) comporte une région où la source lumineuse (1) et la surface (2a) de transmission se font face d'une manière opposée, dans lequel cette région est divisée en une première région (21) et une seconde région (22), située à la périphérie de la première région (21) et contenant une quantité de l'élément de conversion optique inférieure à celle de la première région (21),

dans lequel le rapport de contenu M2 / M1 de l'élément de conversion optique de la seconde région (22) par rapport à la première région (21) a une relation comme suit :

$$M2 / M1 = c / [\{(a - b) \cdot \sqrt{(1 + a^2)}\} \cdot d_1]$$

où

$a = -\tan(\theta + \theta m)$,
$b = -\tan(90° - 2\theta)$,
$c = d2 + 1 \times \tan(90° - 2\theta)$,
$\theta = \tan^{-1}\{1 / (d_2 - d_1)\}$,
$\theta m = \sin^{-1}(1 / nw)$,
$d_1$: hauteur de la partie centrale de la lentille,
$d_2$ : hauteur de la partie périphérique de la lentille,
1 : rayon,
$\theta$ : angle de la partie périphérique de la lentille,
nw : facteur de transmission de la lentille.

2. Dispositif électroluminescent selon la revendication 1, dans lequel :

la surface (2a) de transmission de la lentille devient la plus proche de la source lumineuse (1) sur un axe central passant par un centre de la source lumineuse et devient plus épaisse vers une partie périphérique éloignée d'une surface contenant la source lumineuse,

Fig. 1

Fig. 2

Fig. 3

Fig. 4

Fig. 5

Fig. 6

Fig. 7

Fig. 8

Fig. 9

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007048883 A

- US 20080210961 A1